# EUROPÄISCHE PATENTANMELDUNG

(11) **EP 4 624 970 A1**
(43) Veröffentlichungstag der Anmeldung: **01.10.2025**
(21) Anmeldenummer: 24166848.2
(22) Anmeldetag: 27.03.2024
(51) Int. Cl.: G01R 33/3875, G01R 33/3415

(54) **SHIMSPULENANORDNUNG FÜR MAGNETRESONANZTOMOGRAPH UND VERFAHREN ZUM BETRIEB DES MAGNETRESONANZTOMOGRAPHEN**

(71) Anmelder: Siemens Healthineers AG, 91301 Forchheim (DE)
(72) Erfinder: Biber, Stephan, 91056 Erlangen (DE)
(74) Vertreter: Siemens Healthineers Patent Attorneys

(57) **Zusammenfassung**

Die Erfindung betrifft eine Shimspulenanordnung für eine Bilderfassung eines Knies mit einem Magnetresonanztomographen, eine Kniespule mit der Shimspulenanordnung und ein Verfahren zum Betrieb des Magnetresonanztomographen mit der Kniespule. Die Shimspulenanordnung ist ausgebildet, anterior mit der Kniespule an einem Knie angeordnet zu werden. In dem Verfahren zum Betrieb des Magnetresonanztomographen wird eine B0-Karte des Knies erfasst, Shimströme zur Homogenisierung des B0-Feldes ermittelt und über die Shimspulenanordnung ausgegeben und eine Magnetresonanzaufnahme des Knies erfasst.

## Beschreibung

*Unabhängig vom grammatikalischen Geschlecht eines bestimmten Begriffes sind Personen mit männlicher, weiblicher oder anderer Geschlechteridentität mit umfasst.*

Die Erfindung betrifft eine Shimspulenanordnung für eine Bilderfassung eines Knies mit dem Magnetresonanztomographen sowie Verfahren zum Betrieb des Magnetresonanztomographen mit der Shimspulenanordnung. Die Shimspulenanordnung weist eine anteriore Shimspule zur Homogenisierung eines statischen Magnetfeldes auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Für die Bildgebung sind höchste Anforderungen an Homogenität und Konstanz der magnetischen Felder gestellt. Das statische Magnetfeld selbst führt an Materialgrenzen mit jeweils unterschiedlicher magnetischer Suszeptibilität zu Inhomogenitäten bzw. Sprüngen der Magnetfeldstärke. Dies ist insbesondere in Gelenken mit eng aufeinanderfolgenden Grenzflächen von Muskeln, Fett, Knochen und Knorpel zu lokalen Magnetfeldschwankungen und daraus resultierenden Bildartefakten, beispielsweise an der Kniescheibe bzw. Patella.

Es ist daher eine Aufgabe der vorliegenden Erfindung, eineLokalspule bereitzustellen, die eine Abbildung des Knies verbessert.

Die Aufgabe wird durch eine erfindungsgemäße Shimspulenanordnung nach Anspruch 1, eine Kniespule nach Anspruch 9 sowie ein Verfahren zum Betrieb eines Magnetresonanztomographen mit einer erfindungsgemäßen Kniespule nach Anspruch 12 gelöst.

Die erfindungsgemäße Shimspulenanordnung ist für eine Bilderfassung eines Knies mit einem Magnetresonanztomographen vorgesehen. Dabei ist die Shimspulenanordnung ausgebildet, mit Strom beaufschlagt zu werden und so ein Magnetfeld zu erzeugen, um Inhomogenitäten des statischen Magnetfelds des Magnetresonanztomographen im Abbildungsbereich zu reduzieren. Die Shimspulenanordnung ist ausgebildet, anterior an einem Knie angeordnet zu werden. Insbesondere ist die Shimspulenanordnung ausgebildet, während einer Bilderfassung des Knies in unmittelbarer Nähe der Patella angeordnet zu sein, um durch deren Suszeptibilität verursachten Feldinhomogenitäten auszugleichen.

Die erfindungsgemäße Kniespule bzw. Lokalspule ist zur Bildgebung mit einem Magnetresonanztomographen vorgesehen. Als Kniespule wird hier eine Lokalspule bezeichnet, die besonders für die Abbildung eines Knies geeignet ist. Dafür zeichnet sie sich zum einen durch die mechanische Gestaltung auf. Die Kniespule ist ausgebildet, das Knie in ihrem Inneren aufzunehmen. Beispielsweise kann die Kniespule flexibel gestaltet sein und zur Abbildung um ein Knie herum gelegt werden und dann in ihrer Position z.B. durch Bänder oder andere Befestigungsmittel fixiert werden. Die Kniespule kann aber auch ein starres Gehäuse aufweisen, in das das Knie gelegt wird. Denkbar ist eine Schalenbauweise mit einer oberen Hälfte und einer unteren Hälfte, die für eine Bilderfassung um das Knie herum miteinander verbunden werden. Ebenfalls denkbar sind Mischformen, beispielsweise einer unteren starren Hälfte und einer oberen flexiblen Hälfte, die über das Knie gelegt wird, um einen möglichst engen Kontakt zwischen Knie und Spulenelementen der Kniespule zu ermöglichen. Gemeinsam ist den Bauformen, dass die Kniespule dafür sorgt, dass einzelne Spulenelemente der Kniespule nach dem Anlegen der Kniespule in einer im Wesentlichen reproduzierbaren Relativposition zu dem Knie angeordnet sind. Denkbar ist es dabei, dass die Kniespule ausgebildet ist, einer unterschiedlichen Beugung des Knies angepasst zu werden, beispielsweise indem die starre Kniespule ein Gelenk aufweist oder die flexible Kniespule im angelegten Zustand gebeugt werden kann oder an ein gebeugtes Knie angelegt werden kann.

Die erfindungsgemäße Kniespule weist neben einer oder mehreren Empfangsspulen für ein Magnetresonanzsignal aus dem Knie eine Shimspulenanordnung auf, die aus einer oder einer Mehrzahl von Shimspulen bestehen kann. Als Shimspulen werden hierbei Spulen bezeichnet, die ausgebildet sind, mit einem Strom, nachfolgend auch als Shimstrom bezeichnet, beaufschlagt zu werden, um ein im Wesentlichen statisches Magnetfeld zu erzeugen, das wiederum eine Inhomogenität des statischen Magnetfeldes B0 in einem zu erfassenden Bereich des Knies zumindest teilweise kompensiert bzw. reduziert. Üblicherweise ist der Shimstrom ein Gleichstrom, der sich während der Bilderfassung nicht ändert, zumindest nicht, solange der Patient und seine Position unverändert bleiben. Grundsätzlich ist es dabei denkbar, dass eine Shimspule auch gleichzeitig als Empfangsspule dient, indem eine Frequenzweiche Shimstrom und Magnetresonanzsignal trennt.

Die erfindungsgemäße Lokalspule weist dabei eine Shimspulenanordnung auf, die bei einer anwendungsgemäßen Anordnung der Kniespule an dem Patienten anterior angeordnet. Mit anderen Worten, mindestens eine Shimspule der Shimspulenanordnung ist an der Hälfte bzw. Seite der Kniespule angeordnet, in der bei anwendungsgemäßer Position der Kniespule die Patella ist bzw. die der Patella unmittelbar benachbart ist. Bei einer Mehrzahl an Shimspulen in einer Shimspulenanordnung befinden sich vorzugsweise alle oder der größere Teil in einer anterioren Position.

Auf vorteilhafte Weise ermöglicht eine anteriore Shimspule durch ihre Nähe zur Patella und/oder dem Schienbein insbesondere die durch die Grenzflächen verursachten Magnetfeldinhomogenitäten zumindest teilweise zu kompensieren.

Das erfindungsgemäße Verfahren ist zum Betrieb eines Magnetresonanztomographen mit einer erfindungsgemäßen Kniespule vorgesehen, die eine anterior angeordnete Shimspulenanordnung aufweist. In einem Schritt des erfindungsgemäßen Verfahrens wird zunächst die Kniespule an dem Patienten positioniert, also anwendungsgemäß am bzw. um das abzubildende Knie herum angelegt. Als anwendungsgemäße Position wird es insbesondere angesehen, wenn die Shimspulenanordnung anterior am Knie angeordnet ist. Anschließend wird der Patient so in dem Magnetresonanztomographen positioniert, dass das abzubildende Knie mit der Kniespule in einem Bilderfassungsbereich bzw. Field of View (FoV) des Magnetresonanztomographen zu liegen kommt. Dabei ist es auch denkbar, sofern es der Platz in dem Magnetresonanztomographen erlaubt, zunächst den Patienten zu positionieren und dann die Kniespule anzulegen.

In einem weiteren Schritt wird eine BO-Karte des Knies erfasst. Eine BO-Karte ist eine Abbildung, bei der im Wesentlichen das statische Magnetfeld räumlich in seiner Stärke erfasst bzw. abgebildet wird. Eine BO-Karte kann beispielsweise mit einer modifizierten Spin-Echo-Sequenz erfasst werden. Insbesondere liefert die erfasste BO-Karte ein Maß für durch das Knie bzw. dessen unterschiedliche Gewebearten und die dadurch entstehenden Suzeptibilitätssprünge verursachten Magnetfeldinhomogenitäten.

In einem anderen Schritt ermittelt beispielsweise eine Steuerung des Magnetresonanztomographen anhand der BO-Karte und einer Position der Kniespule relativ zu dem Knie mindestens einen Shimstrom für mindestens eine Shimspule der Shimspulenanordnung, mit der die Feldinhomogenität im zu erfassenden Bereich des Knies reduziert wird.

Die Position des Kniespule kann beispielsweise durch Marker an der Kniespule ermittelt werden, die mittels einer 3D-Kamera oder durch eine Magnetresonanzabbildung erfasst werden. Denkbar sind zu diesem Zweck auch eine vorbestimmte Position der Kniespule durch einen festen Steckplatz am Patiententisch sowie eine bekannte Position des Patiententischs.

Die Geometrie der Shimspule ist im Wesentlichen vorbestimmt, sodass durch das Biot-Savart-Gesetz für einen Shimstrom durch die Shimspule die räumliche Verteilung des Magnetfeldes für die Shimspule berechnet werden kann. Das so erzeugte Magnetfeld überlagert sich zu dem mit der B0-Feldkarte ermitteltem Magnetfeld. Der Shim-Strom wird dann in einem Optimierungsverfahren so ermittelt, dass beispielsweise eine Abweichung des resultierenden überlagerten Magnetfeldes von einem konstanten Wert in einem vorbestimmten Zielvolumen oder dem ganzen FoV minimiert wird. Bei einer Mehrzahl an Shim-Spulen in der Shimspulenanordnung und einer Mehrzahl an Shimströmen ergibt sich entsprechend ein mehrdimensionales lineares Optimierungsproblem, das mit den bekannten mathematischen Mitteln gelöst wird.

In einem weiteren Schritt wird der mindestens eine ermittelte Shimstrom an die Shimspulenanordnung angelegt. Dies kann beispielsweise durch die Steuerung geschehen, die entsprechend mindestens eine mit der Shimpulenanordnung verbundene Shimspule so ansteuert, dass sie den ermittelten Shimstrom an die Shimspulenanordnung ausgibt.

Anschließend wird mit dem Magnetresonanztomographen eine Bilderfassung für das Knie durchgeführt, vorzugsweise mit Empfangsspulen der Kniespule.

Auf vorteilhafte Weise ermöglicht es die erfindungsgemäße Kniespule in Verbindung mit der erfassten BO-Karte, individuell an den Patienten und/oder dessen Position angepasste Verteilung der Shimströme zu ermitteln, um das Ergebnis der Bilderfassung zu optimieren.

Weitere vorteilhafte Ausführungsformen sind zu den Unteransprüchen angegeben.

In einer denkbaren Ausführungsform der erfindungsgemäßen Shimspulenanordnung weist die Shimspulenanordnung eine Shimspule mit konkaver Kontur auf. Darunter ist zu verstehen, dass die Shimspule bzw. ein Trägermaterial mit der darauf angeordneten Shimspule einen nach einer Seite offenen, konkaven Hohlraum bildet bzw. umschließt. Der Hohlraum kann beispielsweise die Form eines Abschnitts einer Kugelhülle, eines Kegelstumpfes, eines kurzen Kreiszylinders oder einer anderen nach einer Seite offenen geometrischen Form aufweisen, der ausgebildet ist, über einem Knie bzw. einer angeordnet zu werden.

So ist es auf vorteilhafte Weise möglich, die Shimspulenanordnung über der konvexen Kontur des Knies und insbesondere der Patella anzuordnen und so eine Nähe der Shimspule als auch eine definierte Position zum Knie zu gewährleisten.

In einer möglichen Ausführungsform der erfindungsgemäßen Shimspulenanordnung weist die Shimspulenanordnung eine Butterfly-Spule als Shimspule auf. Als Butterflyspule wird eine Spule bezeichnet, die vergleichbar einer 8 zwei getrennte Flächen mit entgegengesetztem Wicklungssinn umschließt. Mit anderen Worten wird die Spule mit Strom beaufschlagt, weist das in den beiden Flächen von dem Strom verursachte Magnetfeld entgegengesetzte Richtungen auf. Die Butterflyspule erzeugt auf diese Weise in einem Abstand zu den Flächen ein Feld, das parallel zu diesen Flächen ist und auf vorteilhafte Weise bei anwendungsgemäßer Anordnung von dem Patienten und Shimspule über dem Knie eine Magnetfeldinhomogenität unter der Patella durch ein Feld parallel bzw. antiparallel zu B0 kompensieren kann.

In einer denkbaren Ausführungsform der erfindungsgemäßen Shimspulenanordnung weist diese eine Mehrzahl an Shimspulen auf. Die Shimspulen könnend dabei wie zu den nachfolgenden Unteransprüchen erläutert angeordnet sein.

Auf vorteilhafte Weise ermöglicht eine Mehrzahl an Shimspulen eine Abdeckung einer größeren Fläche und bietet mehr Freiheit bei der Positionierung der Kniespule.

In einer möglichen Ausführungsform der erfindungsgemäßen Shimspulenanordnung ist eine erste Shimspule außenumfänglich von einer zweiten Shimspule umgeben. Beispielsweise können die erste Shimspule und die zweite Shimspule auf einer ebenen oder gekrümmten Oberfläche angeordnet sein. Dabei hat ein Spulenleiter der zweiten Shimspule immer einen größeren Abstand zu einer von beiden Shimspulen umgebenen Fläche als der ein Spulenleiter der ersten Shimspule. Denkbar ist beispielsweise, dass die erste Shimspule und die zweite Shimspule kreisförmige oder elliptische Windungen aufweisen, die konzentrisch auf der Fläche angeordnet sind.

Auf vorteilhafte Weise ermöglichen die beiden Shimspulen, unterschiedliche Feldverteilungen insbesondere bezüglich einer Tiefe in Richtung senkrecht zu den umschlossenen Flächen zu erzeugen und so auf unterschiedliche Geometrien des Knies anzupassen.

In einer Ausführungsform der erfindungsgemäßen Shimspulenanordnung mit einer Mehrzahl an Shimspulen sind mindestens zwei Spulen unabhängig voneinander mit Strom versorgbar. Beispielsweise werden für jede der Shimspulen je zwei Leiter zu einem Stecker zu einem Magnetresonanztomographen geführt. Es ist auch denkbar, dass eine Masse-Leitung bzw. der andere Pol gemeinsam geführt wird und nur jeweils ein Leiter separat für jede Shimspule zur unabhängigen Ansteuerung vorgesehen ist. Denkbar ist auch ein von dem Magnetresonanztomographen steuerbarer Stromverteiler in der Lokalspule, der über mindestens jeweils einen Leiter mit der Shimspule separat verbunden ist und so eine separate Ansteuerung über den Stromverteiler ermöglicht.

Die separate Ansteuerbarkeit der Shimspulen erlaubt eine genauere und insbesondere räumlich anpassbare Kompensation, die auch auf unterschiedliche Patienten und deren Position reagieren kann.

In einer denkbaren Ausführungsform der erfindungsgemäßen Shimspulenanordnung weist die Shimspulenanordnung eine Schaltmatrix auf. Die Schaltmatrix ist ausgebildet, eine Mehrzahl von m Shimspulen der Shimspulenanordnung mit einer Mehrzahl an n Stromquellen zu verbinden, wobei m größer als n ist. Dazu weist die Schaltmatrix beispielsweise n Eingänge auf, die mit den n Stromquellen verbunden sind, beispielsweise über einen entsprechenden Stecker der Kniespule in Verbindung mit dem Patiententisch. Die Schaltmatrix weist weiterhin m Ausgänge auf, die jeweils über zumindest einen Leiter individuell mit den m Shimspulen verbunden sind. Sind die Shimspulen über ein Adernpaar mit den Ausgängen verbunden, ergeben sich weitere Möglichkeiten, beispielsweise Shimspulenpaare flexibel antiparallel zu einer Butterfly-Spule zusammenzuschalten oder parallel oder in Serie zu verschalten. Die Schaltmatrix kann beispielsweise als m x n Crossbar-Matrix mit Schaltern an den Kreuzungspunkten realisiert sein bzw. als 2m x 2n für bipolare Verbindung zu den Shimspulen.

Auf vorteilhafte Weise reduziert die Schaltmatrix die Anzahl der erforderlichen Verbindungen zu der Shimspulenanordnung als auch der erforderlichen Stromquellen. Im Vergleich zu dem bereits angeführten Stromverteiler in der Shimspulenanordnung wird dabei insbesondere eine Abwärme und elektromagnetische Störungen durch Elektronik vermieden.

In einer möglichen Ausführungsform der erfindungsgemäßen Shimspulenanordnung weist mindestens eine Shimspule der Shimspulenanordnung eine Mehrzahl an Windungen auf, die spiralförmig angeordnet sind. Mit spiralförmig wird dabei eine Spule bezeichnet, deren Leiter bzw. Windungen auf einer Fläche angeordnet sind, wobei von einem innenliegenden Startpunkt der Leiter in Windungen um diesen Startpunkt herumgeführt wird, wobei der Abstand von dem Startpunkt mit jeder Windung radial nach außen zunimmt. Dabei gibt es vorzugsweise keine Kreuzung von Windungen der Spule. Denkbar ist, dass der Startpunkt nicht zentral mittig angeordnet ist, sondern am Rand einer zentralen Freifläche der Shimspule liegt. Die zentrale Freifläche kann kreisförmig, elliptisch oder auch unregelmäßig geformt sein. Die Außenkontur der einzelnen Windungen kann sich von Windung zu Windung ändern, ebenso der Abstand zwischen den einzelnen Windungen. Die Fläche, auf der die Leiter angeordnet sind, kann eben sein, aber auch in einer oder mehreren Richtungen gekrümmt oder gewellt sein. Die Fläche kann auch materiell durch ein Trägermaterial realisiert sein, beispielsweise durch eine flexible Leiterplatte.

Auf vorteilhafte Weise erlaubt eine Spiralform der Shimspule eine flache Form. Darüber hinaus ermöglichen die Außenkontur der einzelnen Windungen, deren Abstand zueinander, sowie eine Krümmung der Fläche Freiheitsgrade beim Design einer Shimspule mit einer vorbestimmten zu erzielenden räumlichen Feldverteilung.

In einer möglichen Ausführungsform der erfindungsgemäßen Kniespule ist die Shimspulenanordnung bei einer anwendungsgemäßen Anordnung symmetrisch zu einer Sagittalebene des Patienten. Als Sagittalebene werden hierbei Ebenen angesehen, die bei einem auf dem Rücken liegenden Patienten im Patiententunnel durch die Vektoren der Hochachse und der Längsachse des Patiententunnels aufgespannt werden. Die Kniespule ist dabei symmetrisch zu der Sagittalebene, die mittig durch das Knie verläuft, sodass auch das abzubildende Knie bis auf die Abweichungen durch die unterschiedlichen Ausbildungen von linkem Bein und rechtem Bein das Knie selbst zu dieser Sagittalebene symmetrisch ist.

Bei einer einzelnen Shimspule ist diese beispielsweise mittig zu dieser Ebene am Knie angeordnet, beispielsweise oberhalb der Patella. Bei einer einzelnen Shimspule müsste dies dann wegen der Magnetfeldrichtung in einer Transversalebene durch das Knie angeordnet sein.

Auf vorteilhafte Weise bildet die Symmetrie der Shimspulenanordnung die Symmetrie des Knies ab und reduziert damit den Aufwand bei der Kompensation von Inhomogenitäten.

Vorzugsweise ist die Shimspulenanordnung oberhalb bzw. anterior in einer Reihe entlang der Sagittalebene parallel zu einer Frontalebene des Patienten angeordnet.

An der Vorderseite des Knies und Unterschenkels liegen die Knochen und Knorpel besonders nahe an der Oberfläche, sodass Shimspulen in unmittelbarer Nähe besonders gut geeignet sind von diesen verursachte Suspzeptibilitätssprünge zu kompensieren.

Dabei ist es denkbar, dass Shimspulen paarweise als Butterfly-Spule geschaltet bzw. angesteuert werden und dann trotz flacher Anordnung parallel zur Oberfläche des Knies eine entsprechend Magnetfeldkomponente parallel zur z-Komponente des Magnetfelds B0 unterhalb der Shimspulen erzeugt, die besonders effektiv die Inhomogenität des B0-Feldes kompensiert.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung einer Ausführungsform eines Magnetresonanztomographen mit einer erfindungsgemäßen Kniespule;
- Fig. 2: eine schematische Darstellung einer Ausführungsform einer erfindungsgemäßen Kniespule;
- Fig. 3: eine schematische Aufsicht auf eine Shimspulenanordnung einer Ausführungsform einer erfindungsgemäßen Kniespule;
- Fig. 4: eine schematische Darstellung eines Stromverteilers einer Ausführungsform einer erfindungsgemäßen Kniespule;
- Fig. 5: eine schematische Darstellung einer spiralförmigen Shimspule einer Ausführungsform einer erfindungsgemäßen Kniespule;
- Fig. 6: eine schematische Darstellung einer spiralförmigen Shimspule einer Ausführungsform einer erfindungsgemäßen Kniespule;
- Fig. 7: eine schematische Darstellung einer Shimspule einer Ausführungsform einer erfindungsgemäßen Kniespule;
- Fig. 8: einen schematischen Ablaufplan eines erfindungsgemäßen Verfahrens zum Betrieb eines Magnetresonanztomographen mit der erfindungsgemäßen Kniespule.

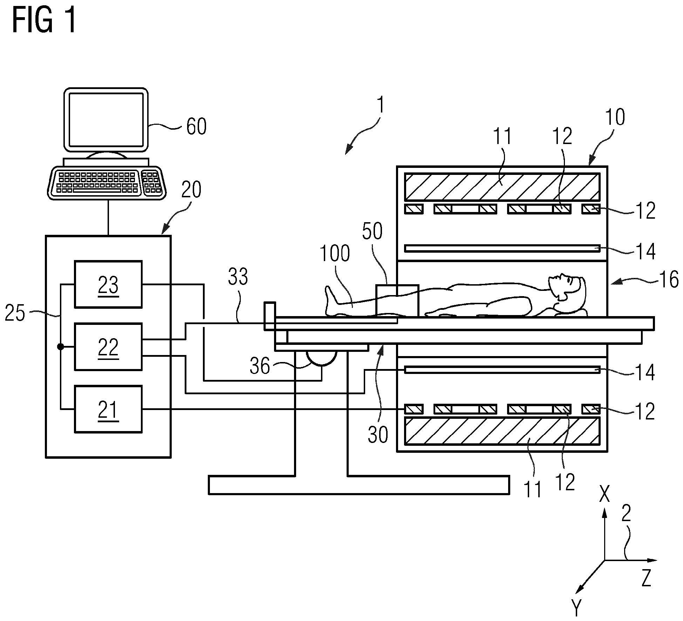

Fig. 1 zeigt eine schematische Darstellung einer Ausführungsform eines Magnetresonanztomographen 1 zur Bilderfassung mit der erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt.

Eine Patientenliege 30 ist in dem Patiententunnel 16 von der Verfahreinheit 36 bewegbar.

Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu eingerichtet sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu eingerichtet ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben. Im Folgenden bezeichnet der Begriff Sendeantenne eine Antenne, über die das Hochfrequenzsignal zur Anregung der Kernspins ausgestrahlt wird. Dies kann die Körperspule 14 sein, aber auch eine Lokalspule 50 mit Sendefunktion.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu eingerichtet ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die eingerichtet ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

An dem Patienten 100 ist eine Kniespule 50 angeordnet, die über eine Anschlussleitung 33 mit der Hochfrequenzeinheit 22 und deren Empfänger verbunden ist.

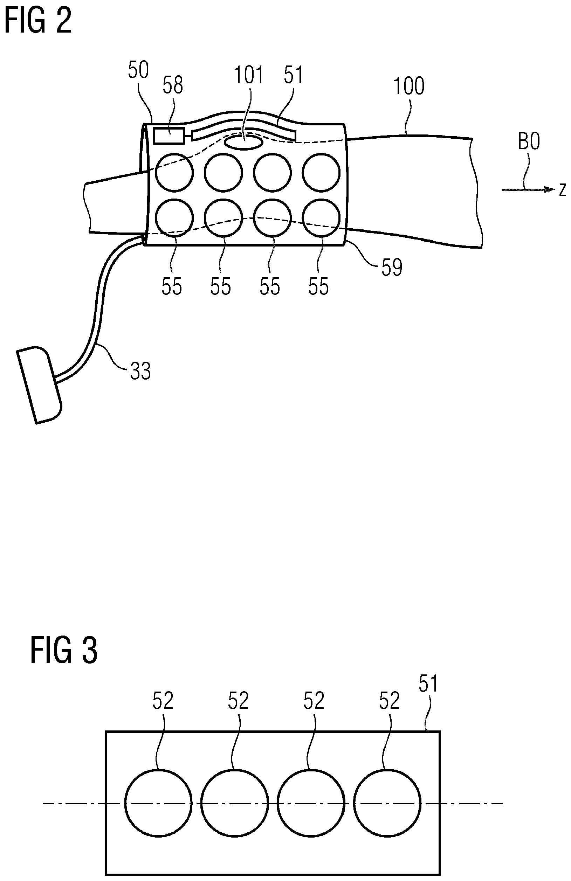

In Fig. 2 ist eine Ausführungsform der erfindungsgemäße Kniespule 50 näher dargestellt. Die Kniespule 50 weist eine Hülle bzw. ein Gehäuse 59 auf. Das Gehäuse 59 kann beispielsweise aus zwei Hartschalen aus Kunststoff bestehen, die aufgeklappt oder getrennt werden können, sodass das Knie des Patienten 100 eingelegt bzw. positioniert werden kann. Anschließend kann das Gehäuse 59 wieder um das Knie geschlossen werden. Es ist auch denkbar, dass das Gehäuse 59 flexibel ausgebildet ist, beispielsweise aus einer Tasche aus Textilmaterial, in das die nachfolgend genannten Komponenten eingearbeitet sind. Eine derartige Kniespule kann um das Knie gewickelt und anschließend mit einem Klettverschluss oder einer anderen Schließe fixiert werden. Das Gehäuse dient dazu, die darin angeordneten Komponenten, insbesondere eine Shimspulenanordnung 51, in einer vorbestimmten Relativposition zu dem Patienten 100 zu positionieren.

Die Kniespule 50 weist eine Shimspulenanordnung 51 auf, die anterior, das heißt bei der üblichen anwendungsgemäßen Anordnung von Patient 100 und Kniespule 50, über dem Knie bzw. der Kniescheibe 101 zu liegen kommt. Die Kniescheibe 101 wird medizinisch auch als Patella bezeichnet.

Die Kniespule weist weiterhin eine Mehrzahl an Antennenspulen 55 auf, die vorzugsweise als Matrix bzw. Array in der Kniespule so angeordnet sind, dass sie in anwendungsgemäßer Position der Kniespule 50 möglichst gleichmäßig um das Knie herum verteilt und nahe am Patient 100 zu liegen kommen. Die von den Antennenspulen 50 aufgenommenen Magnetresonanzsignale werden über die Anschlussleitung 33 zur Auswertung an den Magnetresonanztomographen 1 übertragen.

Die Shimspulenanordnung 51 wird im Betrieb mit Strom versorgt, um die Magnetfelder zur Kompensation zu erzeugen. Dies kann dadurch erfolgen, dass über die Anschlussleitung 33 mittels je eines Leiterpaares einer bzw. jeder Shimspule 52 der Shimspulenanordnung 51 individuell ein Strom zugeführt wird. Denkbar ist es aber auch, dass ein Stromverteiler 58 einen der Kniespule 50 zugeführten Strom bzw. mehrere Ströme auf die Shimspulen 52 der Shimspulenanordnung 51 verteilt. Unterschiedliche Ausführungsformen des Stromverteilers 58 sind nachfolgen erläutert.

Fig. 3 zeigt eine schematische Aufsicht auf eine Shimspulenanordnung 51 einer Ausführungsform einer erfindungsgemäßen Kniespule 50. Die Aufsicht ist von oben auf die Shimspulenanordnung 51, d.h. senkrecht auf die Frontalebene. In der Darstellung der Fig. 3 ist beispielhaft eine Shimspulenanordnung 51 mit vier Shimspulen 52 angegeben. Die Shimspulen 52 sind in einer Reihe angeordnet, in Anwendungsposition entlang einer Sagittalebene durch das Knie und vorzugsweise spiegelsymmetrisch zu dieser. Auf diese Weise entspricht die Anordnung der Shimspulen 52 auch der im Wesentlichen symmetrischen Form des Beins und Knies relativ zu dieser Sagittalebene. Die Anzahl der Shimspulen 52 ist hier mit vier Shimspulen 52 beispielhaft, es ist für die flache Anordnung entlang der Frontalebene jede Anzahl größer gleich zwei denkbar.

In der Darstellung der Fig. 3 sind die Shimspulen 52 planar in der Transversalebene oder bei einer Anordnung am Knie des Patienten 100 etwas um das Bein des Patienten herum gekrümmt, um eine flache bzw. dünne Bauweise der Kniespule zu ermöglichen. Das von einer einzelnen stromdurchflossenen Shimspule 52 erzeugte Magnetfeld ist damit im Wesentlichen senkrecht zur Fläche der Shimspule 52, zu der Transversalebene und zu dem Magnetfeld B0. Um hingegen ein zu B0 paralleles bzw. antiparalleles Kompensationsfeld zu erzeugen, müssen zwei benachbarte Shimspulen 52 so miteinander verschaltet werden bzw. mit Strom beaufschlagt werden, dass sie antiparallele Magnetfelder erzeugen, die durch Überlagerung unterhalb (und oberhalb) der benachbarten Shimspulen 52 in einer Symmetriebene zu den Shimspulen 52 zwischen den benachbarten Shimspulen 52 die erwünschte zu B0 parallele Komponente erzeugen. Der gleiche Effekt kann auch mit einer einzelnen Shimspule 52 in Form einer Butterflyspule erzielt werden.

Grundsätzlich lässt sich ein derartiges Kompensationsfeld mit zu B0 parallelen Komponenten auch durch eine einzelne Shimspule 52 erzeugen, die in einer Transversalebene angeordnet ist, also senkrecht zu B0 ausgerichtet ist. Diese Anordnung erfordert jedoch eine zusätzliche Bauhöhe, um eine von dem Knie senkrecht abstehende Shimspule 52 unterzubringen.

Sind jedoch die Shimspulen 52 der Fig. 3 einzeln und in ihrer Polarität unabhängig voneinander ansteuerbar, so lässt sich aus unterschiedlichen benachbarten Spulenpaaren jeweils eine Butterflyspule zusammenschalten, sodass der Ort des Kompensationsfeldes entlang der z-Richtung bzw. des B0-Feldes verändert werden kann. Auf diese Weise ist es beispielsweise denkbar, dass das Kompensationsfeld entlang der z-Achse verschoben werden kann, um bei einer schichtweisen Abtastung entlang der z-Achse jeweils in der aktuell abzutastenden Schicht die Kompensation zu optimieren.

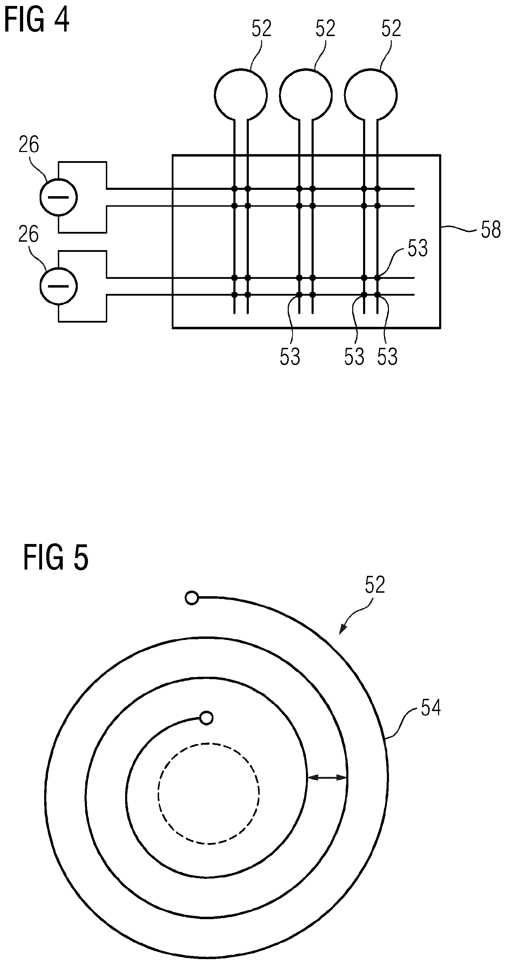

In Fig. 4 ist eine Ausführungsform eines Stromverteilers 58 einer erfindungsgemäßen Kniespule 50 schematisch dargestellt. Der Stromverteiler 58 der Fig. 4 ist als Cross-Bar-Matrix ausgebildet.

Es sind hier beispielhaft zwei Stromquellen 26 des Magnetresonanztomographen 1 dargestellt, die über Leiter und Kontakte der Anschlussleitung 33 mit dem Stromverteiler 58 galvanisch verbunden sind und dort auf Stromschienen (Bar) geführt sind. In gleicher Weise sind die Anschlüsse elektrisch mit Stromschienen verbunden, die die mit den Stromquellen verbundenen Stromschienen kreuzen. An den Kreuzungspunkten sind Schalter 53 angebracht, die von dem Magnetresonanztomographen 1 gesteuert werden können und so selektiv senkrechte Leiterbahnen bzw. Stromschienen mit horizontalen Leiterbahnen verbinden können. Die Schalter 53 können beispielsweise als MEMS-Schalter ausgeführt sein, die über eine Steuerleitung in der Anschlussleitung 33 und einem Prozessor in dem Stromverteiler 58 von dem Magnetresonanztomographen 1 kontrolliert werden.

Indem beide Pole der Stromquelle 26 und der jeweiligen Shimspulen 52 auf die Cross-Bar-Matrix geführt sind, kann mit geeigneter Schalterstellung der Schalter 53 ein beliebiges Paar an Shimspulen 52 zu einer Butterfly-Spule verschaltet und angesteuert werden. Die Stärke des Kompensationsfeldes kann dabei von dem Magnetresonanztomographen 1 über die Stromquellen 26 eingestellt werden.

Die Anzahl der Stromschienen kann reduziert werden, wenn die Shimspulen 52 und/oder die Stromquellen 26 einen gemeinsamen Pol haben, beispielsweise einen Massepol. Vorteilhaft ist es in diesem Fall, wenn die Stromquelle 26 die Polarität wechseln kann.

Denkbar ist es auch, dass in dem Stromverteiler 58 selbst die einstellbaren Stromquellen 26 vorgesehen sind, die jeweils mit einer Shimspule 52 verbunden sind und so individuelle Ströme oder auch Polaritäten bereitstellen können. Es ist dann nur ein gemeinsames Leiterpaar in der Anschlussleitung 33 für die Stromzuführung zu den Stromquellen 26 erforderlich, jedoch müssen die Stromquellen gegen Wechselwirkungen mit der Bildgebung geschützt sein und eine entstehende Verlustwärme ist abzuführen.

Fig. 5 zeigt eine schematische Darstellung einer spiralförmigen Shimspule 52 einer erfindungsgemäßen Kniespule. Die Shimspule 52 kann beispielsweise als Leiterbahn 54 auf einer flexiblen Leiterplatte ausgeführt sein. Dadurch wird die Geometrie der Shimspule 52 in großem Maß variabel, insbesondere durch den Abstand zueinander und die Kontur der Leiterbahn. Beispielsweise ist es denkbar, dass der radiale Abstand der einzelnen Windungen zueinander nach außen beispielsweise abnimmt oder zunimmt. Auch ist die Kontur der Shimspule 52 variabel, beispielsweise kann von einer annähernd kreisförmigen Form der innersten Windung zu einer ovalen oder auch polygonalen Form der äußeren Windung variiert werden. Auf diese Weise kann die räumliche Feldverteilung der Shimspule 52 für eine spezifische Geometrie der Knies und der davon hervorgerufenen Inhomogenität optimiert werden.

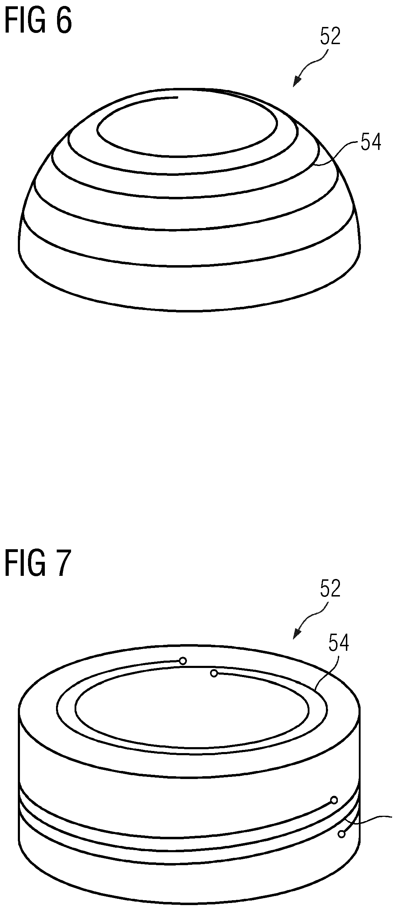

Fig. 6 zeigt eine beispielhafte Shimspule 52 einer erfindungsgemäßen Shimspulenanordnung 51. Die Shimspule 52 weist eine oder mehrere Windungen eines Spulenleiters 54 auf, die auf einem Trägermaterial angeordnet ist. Das Trägermaterial kann beispielsweise eine flexible Leiterplatte sein, auf der als Spulenleiter 54 eine Leiterbahn angebracht ist. Das Trägermaterial ist vorzugsweise konkav ausgeformt, sodass diese an die Kontur des Knies bzw. der Patella angepasst ist und an dieser während einer Aufnahme platziert werden kann.

Es ist dabei auch denkbar, dass die Shimspulenanordnung 51 bzw. die Shimspule 52 nicht fester Bestandteil einer Kniespule 50 ist, sondern separat am Knie angeordnet wird, bevor dieses in der Kniespule 50 positioniert wird. Die Shimspulenanordnung kann dann beispielsweise an eine Buchse der Kniespule 50 angeschlossen werden und über diese mit Strom versorgt werden. Denkbar ist auch ein Adapterstecker, der in einen Steckplatz eines Patiententischs eingesteckt wird und der dann sowohl die Kniespule 50 als auch die Shimspulenanordnung 51 mit dem Magnetresonanztomographen 1 verbindet.

In Fig. 7 ist eine weitere Ausführungsform einer erfindungsgemäßen Shimspulenanordnung 51 dargestellt. Das Trägermaterial ist hier in Form eines Zylinders mit Deckel ausgeführt. Auf dem Deckel befindet sich eine erste Shimspule 52 und außenumfänglich um den Mantel des Zylinders ist eine zweite Shimspule 52 angeordnet. Vorzugsweise sind die beiden Shimspulen 52 separat mit Shimspulenströmen ansteuerbar, sodass das erzeugte Magnetfeld der Shimspulenanordnung 51 der Fig. 7 in seiner Ausformung entlang einer Rotationsachse des Zylinders variiert werden kann. Wird eine derartige Shimspulenanordnung 51 an einem Knie angeordnet, so ist es auf vorteilhafte Weise auch möglich, durch die Variation der Shimströme in der ersten und der zweiten Shimspule 52 Inhomogenitäten nicht nur unter der Patella zu kompensieren, sondern auch seitlich davon.

Denkbar sind im Sinne der Erfindung auch andere Kombinationen und Variationen der in den einzelnen Figuren dargestellten Shimspulenanordnungen 51 und Shimspulen 52. Beispielsweise wäre auf dem Deckel des Zylinders in Fig. 7 anstelle der ersten kreisförmigen Shimspule 52 eine Butterflyspule angeordnet sein.

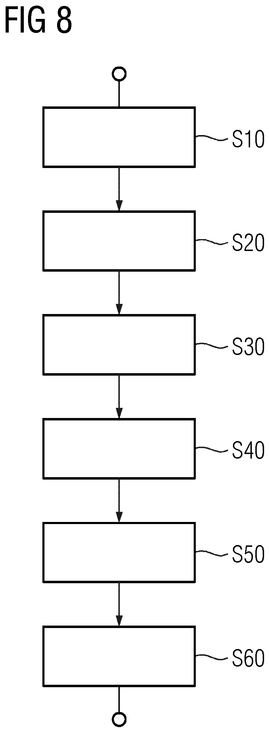

Fig. 8 zeigt einen schematischen Ablaufplan eines erfindungsgemäßen Verfahrens zum Betrieb eines Magnetresonanztomographen mit der erfindungsgemäßen Kniespule 50. In einem Schritt S10 des Verfahrens wird die erfindungsgemäße Kniespule 50 am Knie des Patienten 100 positioniert, wobei die Shimspulenanordnung 51 in unmittelbarer Nähe zur Kniescheibe 101 zu liegen kommt.

In einem anderen Schritt S20 wird der Patient 100 in dem Magnetresonanztomographen 1 positioniert, sodass das Knie von dem Magnetresonanztomographen 1 in einer Bildgebung erfasst werden kann. In dem Magnetresonanztomographen 1 der Fig. 1 muss dabei das Knie in dem Patiententunnel 16 in dem sogenannten Field-of-View zu liegen kommen.

In einem Schritt S30 wird eine BO-Karte des Knies mit dem Magnetresonanztomographen 1 erfasst. Als BO-Karte wird eine Magnetresonanzaufnahme bezeichnet, die für die erfassten Volumenelemente eine Stärke des statischen Magnetfeldes B0 wiedergibt, insbesondere eine Abweichung von einem Mittelwert. Derartige B0-Karten werden im Stand der Technik üblicherweise mit Varianten einer Spin-Echo-Sequenz erfasst.

Anhand der BO-Karte sind die Abweichungen der Stärke des statischen Magnetfeldes B0 am Knie bekannt und somit auch die an dem jeweiligen Ort erforderliche Stärke eines Kompensationsfeldes. Es werden in einem Schritt S40 die Stromstärken ermittelt, die durch eine oder mehrere Shimspulen fließen müssen, um diese B0-Abweichungen zumindest teilweise zu kompensieren. Dies erfolgt vorzugsweise durch die Steuerung 23 des Magnetresonanztomographen 1. Zunächst muss die Lage der Shimspulen 52 relativ zu dem Magnetresonanztomographen 1 bzw. dessen Magnetfeld B0 bekannt sein. Diese kann beispielsweise durch die Position des Patiententisches 30 vorgegeben sei, wenn die Kniespule 50 über den Steckplatz in ihrer Position definiert ist. Denkbar sind auch optische Markierungen an der Kniespule, die mittels einer oder mehrerer Kameras erfasst werden, um die Position zu ermitteln. Bei bekannter Position und Form der Shimspulen 52 kann dann mittels des Biot-Savart-Gesetzes für jeden Ort das von der Shimspule 52 erzeugte Magnetfeld in Abhängigkeit vom Strom ermittelt werden. Die Ermittlung der Stromstärken durch eine oder mehrere Shimspulen 52 wird damit zu einem Optimierungsproblem, bei dem eine Abweichung des überlagerten Magnetfeldes B0 mit dem bzw. den Feldern der Shimspulen 52 von einem Mittelwert minimiert wird. Als Randbedingungen können dabei Verschaltungen der Shimspulen 52 berücksichtigt werden, wie sie beispielsweise durch den Stromverteiler 58 verursacht werden. Eine Symmetrie der Shimspulenanordnung 51, beispielsweise zur Sagittalebene durch das Knie, kann dabei ebenfalls das Lösen des Optimierungsproblems vereinfachen und dadurch beschleunigen.

In einem Schritt S50 werden von dem Magnetresonanztomographen 1 die ermittelten Shimströme an die jeweiligen Shimspulen 52 angelegt. Das kann das Einstellen der Stromquellen 26 umfassen als auch das Einstellen des Stromverteilers 58 bzw. der Schalter 53 darin

In einem Schritt S60 wird schließlich eine Magnetresonanzabbildung erfasst, in der die Artefakte durch die B0-Inhomogenitäten reduziert sind.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Shimspulenanordnung für eine Bilderfassung eines Knies mit einem Magnetresonanztomographen (1), wobei die Shimspulenanordnung (51) ausgebildet ist, anterior an einem Knie angeordnet zu werden.

2. Shimspulenanordnung nach Anspruch 1, wobei die Shimspulenanordnung (51) eine Shimspule (52) mit konkaver Kontur aufweist, die ausgebildet ist, über einer Kniescheibe 101 angeordnet zu werden.

3. Shimspulenanordnung nach Anspruch 1, wobei die Shimspulenanordnung (51) eine Butterfly-Spule aufweist.

4. Shimspulenanordnung nach einem der vorhergehenden Ansprüche, wobei die Shimspulenanordnung (51) eine Mehrzahl an einzelnen Shimspulen (52) aufweist.

5. Shimspulenanordnung nach Anspruch 4, wobei eine erste Shimspule (52) außenumfänglich von einer zweiten Shimspule (52) umgeben ist.

6. Shimspulenanordnung nach Anspruch 4 oder 5, wobei mindestens zwei der Shimspulen (52) voneinander unabhängige Stromversorgungen aufweisen.

7. Shimspulenanordnung nach Anspruch 6, wobei die Shimspulenanordnung (51) einen Schaltmatrix aufweist, die ausgebildet ist, eine Mehrzahl von m Shimspulen (52) der Shimspulenanordnung (51) mit einer Mehrzahl an n Stromquellen zu verbinden, wobei m > n ist.

8. Shimspulenanordnung nach einem der vorhergehenden Ansprüche, wobei eine Shimspule (52) der Shimspulenanordnung (51) eine Mehrzahl an Windungen aufweist, die spiralförmig angeordnet sind.

9. Kniespule für einen Magnetresonanztomographen (1), wobei die Kniespule (50) eine Shimspulenanordnung (51) nach einem der vorhergehenden Ansprüche aufweist, die bei einer anwendungsgemäßen Anordnung der Kniespule (51) am Patienten (100) anterior angeordnet ist.

10. Kniespule nach Anspruch 9, wobei die Shimspulenanordnung (51) bei einer anwendungsgemäßen Anordnung symmetrisch zu einer Sagittalebene des Patienten (100) ist.

11. Kniespule nach einem der Ansprüche 9 oder 10, wobei die Shimspulenanordnung (51) mittig entlang einer Längsachse in der Kniespule (51) angeordnet ist.

12. Verfahren zum Betrieb eines Magnetresonanztomographen (1) mit einer Kniespule (50) nach einem der vorhergehenden Ansprüche 9 bis 11, wobei das Verfahren die Schritte aufweist:
- (S10) Positionieren der Kniespule (50) an einem Patienten (100);
- (S20) Positionieren des Patienten (100) in dem Magnetresonanztomographen (1);
- (S30) Erfassen einer BO-Karte des Knies mit dem Magnetresonanztomographen (1);
- (S40) Ermitteln mindestens eines Shim-Stroms, bei dessen Applikation an der Shimspulenanordnung (51) eine Homogenität des B0-Feldes verbessert wird;
- (S50) Anlegen des ermittelten Shim-Stromes an die Shimspulenanordnung (51);
- (S60) Erfassen einer Abbildung des Knies mit dem Magnetresonanztomographen (1).
